# EUROPÄISCHE PATENTSCHRIFT

(11) **EP 3 211 606 B1**
(45) Veröffentlichungstag und Bekanntmachung des Hinweises auf die Patenterteilung: **16.02.2022**
(21) Anmeldenummer: 17158078.0
(22) Anmeldetag: 27.02.2017
(51) Int. Cl.: G07C 5/00, H04W 84/12, B60L 3/00, G01R 31/36, G01R 31/371, G01R 31/3835

(54) **BATTERIEÜBERWACHUNGSMODUL**
BATTERY MONITORING MODULE
MODULE DE SURVEILLANCE DE LA BATTERIE

(30) Priorität: 29.02.2016 DE 102016002311
(43) Veröffentlichungstag der Anmeldung: 30.08.2017
(73) Patentinhaber: Ammann Schweiz AG, 4901 Langenthal (CH)
(72) Erfinder: Trimborn, Martin, 53179 Bonn (DE)
(74) Vertreter: Schatz, Markus Franz-Josef

(56) Entgegenhaltungen:
- WO-A1-2004/106883
- WO-A1-2015/138930
- WO-A2-2014/125222
- DE-A1- 10 200 922
- DE-U1-202013 002 618
- JP-A- 2015 220 668
- US-A1- 2010 120 373
- US-A1- 2015 154 816
- US-A1- 2015 204 758
- US-A1- 2016 057 635

## Beschreibung

Die Erfindung betrifft eine Anordnung aus einer Baumaschine und einem Überwachungsmodul zur Erfassung von Betriebsparametern der Baumaschine, die eine Starterbatterie aufweist und über einen Zündschalter gestartet werden kann, sowie ein Verfahren zur Überwachung zumindest eines Betriebsparameters einer Baumaschine, wobei die Betriebsparameter zumindest die Spannung einer Starterbatterie umfassen.

### Stand der Technik

Aus dem Bereich der Elektromobilität sind Batterieüberwachungsmodule als integrierte Bestandteile von Traktionsbatterien für Elektrofahrzeuge bekannt. In diesen kommen entsprechenden Steuerungsmodule, dort Battery-Control-Units, kurz BCUs genannt, zum Einsatz, welche umfangreiche Aufgaben zur optimalen Kapazitätsausnutzung, der zur Ladung der Batterie, dem Ladungsausgleich zwischen Zellen, etc. ausüben. Derartige Steuerungsmodule sind in der Regel über eine Vielzahl von Sensoren und Schaltern stark mit der Traktionsbatterie sowie einer Fahrzeugsteuerung vernetzt. Derartige Module sind somit ein fester, integrierter Bestandteil eines komplexen Steuerungssystems, welches ohne ein entsprechendes Batterieüberwachungsmodul nicht funktionsfähig wäre.

### Offenbarung der Erfindung

Zwecks Senkung von Produktionskosten beschreibt die JP 2015 220668 A ein "ON-VEHICLE COMMUNICATION DEVICE", wozu ein In-Vehicle

Communication Device vorgeschlagen wird, welches in einem ersten Kommunikations-Modus (AP-Modus) eine Kommunikation mit einem im Fahrzeug montierten Device (beispielsweise einem Reifendrucksensor) vorsieht, um eine interne Fahrzeugverkabelung einzusparen, und in einem zweiten Modus (STA-Modus) eine Kommunikation mit einem externen Device (Access Point eines Netzwerks) vorsieht, um die empfangen Fahrzeugdaten, wie beispielsweise der Reifendruck, nach außen weiterzuleiten. Dieser STA-Modus wird durch den Übergang in einen nicht antreibbaren Zustand vom Umschalten auf AUS des Zundschalters implementiert.

Die DE 102 00 922 A1 beschreibt ein Ferndiagnosesystem für ein Kraftfahrzeug, welches einen mit einer stationären Diagnoseeinheit koppelbaren, fahrzeugfesten Diagnosestecker zum Auslesen von Daten aus einem Fahrzeug-Netzwerk und/oder über an Fahrzeugkomponenten angeschlossene Diagnoseleitungen umfasst. Dem Diagnosestecker ist über eine Schnittstelle ein programmierbarer Adapter zugeordnet, der über einen fahrzeugseitigen Sender ausgewählte Daten an einen ortsfesten Zentralrechner übermittelt.

In der DE 20 2013 002618 U1 wird eine Batterieüberwachungsvorrichtung für ein Kraftfahrzeug mit einem Spannungssensor zum Erfassen der Spannung einer Batterie des Kraftfahrzeugs beschrieben, wobei die Überwachungsvorrichtung eine Beurteilungseinheit zum Beurteilen des Zustands der Batterie anhand der erfassten Spannung und eine Funkschnittstelle zum Übertragen eines Beurteilungsergebnisses der Beurteilungseinheit an ein Anzeigegerät aufweist, und wobei die Beurteilungseinheit eingerichtet ist, das Beurteilungsergebnis selbsttätig zu übertragen, wenn sie eine Störung der Batterie feststellt.

In der US 2015/204758 A1 wird ein Flottenmanagementsystem beschrieben, welches einen Batteriestand einer Maschine in Form einer Spannung oder eines Stromes überwachen kann. Eine Steuerung oder ein Server können Batteriestandsdaten von der Maschine empfangen. Wenn ein erfasster Batteriestand unter einen minimalen Batteriestand fällt, kann der Server eine Warnmeldung über einen niedrigen Batteriestand für ein mobiles Gerät generieren.

Im Unterschied zur komplexen Überwachung und Steuerung einer Traktionsbatterie ist die Aufgabe der vorliegenden Erfindung die Angabe einer Lösung für die einfache Überwachung einer Spannung einer Starterbatterie, welche mitunter über längere Zeit nicht nachgeladen wird. Dieses Problem stellt sich beispielsweise bei einem Fuhrpark von Baumaschinen, wobei zwischen mehreren Einsätzen der Baumaschinen, beispielsweise jahreszeitlich bedingt, längere Benutzungspausen liegen können. Aufgabe ist es, durch Batterieausfall bedingte Wartungsaufwände und -kosten beispielsweise durch frühzeitige Erkennbarkeit von Spannungsabfällen minimieren zu können. Dabei ist es ferner Aufgabe, dass auch und gerade in Einsatzszenarien mit vielen gleichzeitig zu überwachenden Baumaschinen die Überwachung mit geringem Personal- und Zeiteinsatz möglich ist.

Die Lösung der Aufgabe erfolgt erfindungsgemäß durch die Merkmale der unabhängigen Ansprüche. Vorteilhafte Ausgestaltungen der Erfindung sind in den Unteransprüchen angegeben.

Gegenstand der Erfindung ist eine Anordnung aus einer Baumaschine und einem Überwachungsmodul zur Erfassung von Betriebsparametern einer Baumaschine, die über einen Zündschalter gestartet werden kann, wobei die Betriebsparameter zumindest die Spannung einer Starterbatterie der Baumaschine umfassen. Gegenstand der Erfindung ist ferner ein Verfahren zur Überwachung zumindest eines Betriebsparameters einer Baumaschine, wobei die Betriebsparameter zumindest die Spannung einer Starterbatterie umfassen.

Erfindungsgemäß vorgesehen ist eine Anordnung aus einer Baumaschine und einem Überwachungsmodul zur Erfassung von Betriebsparametern der Baumaschine, die eine Starterbatterie aufweist und über einen Zündschalter gestartet werden kann, wobei die Betriebsparameter zumindest die Spannung der Starterbatterie der Baumaschine umfassen, und wobei das Überwachungsmodul zur drahtlosen Übermittlung der Betriebsparameter eine Funkkommunikationseinrichtung aufweist,
wobei das Überwachungsmodul ein Stecker- oder Buchsen- Element einer mehrpoligen elektrischen Steckverbindung zur Verbindung mit der Baumaschine aufweist, über die es lösbar mit den Polen der Starterbatterie und mit dem Zündschalter verbunden ist und eingerichtet ist, in einem Aus-Zustand des Zündschalters die Funkkommunikationseinrichtung in dem Station-Mode zur Funkkommunikation mit einem Access-Point zu betreiben und eine Übermittlung der erfassten Betriebsparameter an eine vorgebbare Funkkommunikationseinrichtung im Access-Point-Mode vorzunehmen, und in einem Ein-Zustand des Zündschalters die Funkkommunikationseinrichtung in einem Access-Point-Mode zur Funkkommunikation mit einer Station zu betreiben und eine Übermittlung der erfassten Betriebsparameter eine vorgebbare Station vorzunehmen.

Dabei bedeutet eine Verbindung mit einem Zündschalter eine Verbindung mit dem schaltbaren Kontakt des Zündschalters, so dass anhand beispielsweise der Spannung an dem Kontakt erkennbar ist, ob sich der Zündschalter in einem Ein-Zustand oder einem Aus-Zustand befindet.

Bekannt kann ein Überwachungsmodul den Vorteil bieten, mit sehr wenigen, in der Regel nur drei Verbindungen mit einer Antriebsmaschine verbindbar zu sein, deren Starterbatterie überwacht werden soll. Dabei bietet eine Ausführung der Verbindung als lösbare Steckverbindung den Vorteil, dass das Überwachungsmodul beispielsweise lediglich temporär, d.h. nur bei Bedarf mit der Antriebsmaschine verbunden werden kann. Des Weiteren kann es den Vorteil bieten, dass es im Defektfall sehr einfach zu entfernen bzw. auszutauschen ist. Auch in einem Wartungsfall, beispielsweise für ein Softwareupdate, kann das Modul temporär von der Antriebsmaschine gelöst werden. Darüber hinaus bietet eine Ausführung des Überwachungsmoduls mit einem einheitlichen Stecker, beispielsweise einem Standard-Industrie Stecker, einem Standard KFZ-Steckrelais-Stecker oder einem standardisierten OBD-Stecker (On-Board-Diagnose-Stecker) den Vorteil, dass es einheitlich in größerer Stückzahl zu fertigen ist. Darüber hinaus weisen viele Antriebsmaschinen bereits entsprechende Buchsen bzw. Kupplungen zum Anschluss eines derartigen Steckers auf, so dass in vielen Anwendungsfällen für die Verbindung eines Überwachungsmoduls mit der Antriebsmaschine keine baulichen Maßnahmen erforderlich sind. Ebenfalls bekannt kann ein Überwachungsmodul als Stecker-Element einen Steckkontakt gemäß einem Standard-Industriestecker, einem Standard-KFZ-Steckrelais oder einem Standard-OBD-Konnektors aufweisen.

Weiterhin bekannt kann das Modul zur Übermittlung von Betriebsparametern, insbesondere der Spannung der Starterbatterie, eine Funkkommunikationseinrichtung aufweisen, so dass die Übermittlung drahtlos erfolgen kann. Die Übermittlung kann über WLAN nach dem IEEE 802.11 Standard erfolgen.

Das Überwachungsmodul der erfindungsgemäßen Anordnung ist in zwei Betriebsmodi betreibbar, wobei der Betriebsmodus von dem Schaltzustand des Zündschalters abhängig ist. Dabei ist die Funkkommunikationseinrichtung sowohl zum Betrieb in einem Station-Mode zur Funkkommunikation mit einem Access-Point als auch zum Betrieb in einem Access-Point-Mode zur Funkkommunikation mit einer Station eingerichtet.

Wird eine Funkkommunikationseinrichtung in einem Access-Point Mode betrieben, so wird durch diese Funkkommunikationseinrichtung aktiv eine Funkzelle ausgebildet. Dazu sendet die Funkkommunikationseinrichtung ein "Beacon" genanntes Trägersignal aus, durch dessen Reichweite die Größe der Funkzelle beschrieben wird. Der Beacon enthält unter anderem Informationen, anhand derer die Art der Funkzelle, der Betreiber, etc. identifiziert werden können. Wird die Funkkommunikationseinrichtung als Access-Point nach dem IEEE 802.11 WLAN- Standard betrieben, so versendet sie im Normalfall in kurzen, sich wiederholenden Abständen über den Beacon eine sogenannte SSID, einen Service Set Identifier, anhand dessen der Name des Funknetzes erkannt werden kann.

Wird eine Funkkommunikationseinrichtung in einem Station Mode betrieben, so stellt diese Funkkommunikationseinrichtung eine im Wesentlichen passive Empfangs-Station in einer Funkzelle dar, die lediglich im Bedarfsfall eine (Nutz-) Datenverbindung zu einem zentralen Access-Point aufbaut. Aus diesem Grund ist der Energieverbrauch einer Funkkommunikationseinrichtung bei einem Betrieb in einem Station-Mode deutlich geringer als bei einem Betrieb im Access-Point-Mode.

Das Überwachungsmodul ist - abgesehen von Konfigurationsparametern wie beispielsweise einem Netzwerknamen - dazu eingerichtet, in einem Aus-Zustand des Zündschalters in dem Station-Mode, und in einem Ein-Zustand des Zündschalters in dem Access-Point-Mode zu arbeiten. Das Überwachungsmodul bietet den ersten Vorteil, dass der Energieverbrauch des Überwachungsmoduls mit dem Schaltzustand des Zündschalters, und somit in der Regel von dem Betrieb der Baumaschine gekoppelt ist. Bei ausgeschalteter Zündung ist der Energiebedarf der Funkkommunikationseinrichtung sehr gering, bei eingeschalteter ist er sehr viel höher. Bei eingeschalteter Zündung wird jedoch in der Regel durch den Betrieb der Baumaschine zusätzliche elektrische Energie über eine Lichtmaschine erzeugt, so dass der höhere Energiebedarf der Funkkommunikationseinrichtung unerheblich ist. Zeiträume, in denen ein Zündschalter geschlossen ist, in denen die Baumaschine jedoch nicht in Betrieb ist, sind in der Regel so kurz, dass sie hinsichtlich der Entladung der Starterbatterie unerheblich sind.

Darüber hinaus bietet dieses Merkmal den zweiten Vorteil, dass über die Betätigung des Zündschalters manuell ein lokales Funknetz eingeschaltet, bzw. funktechnisch aufgebaut werden kann. Dieses lokale Funknetz kann von einer weiteren, im Station-Mode operierenden Funkkommunikationseinrichtung, kurz Station genannt, erkannt und zum Aufbau einer Verbindung genutzt werden. Dabei kann die weitere Funkkommunikationseinrichtung beispielsweise eine Funkschnittstelle eines Datenerfassungsterminals sein, mit Hilfe dessen die Betriebsparameter aus der Überwachungsvorrichtung ausgelesen werden. Dazu weist das Überwachungsmodul vorteilhaft eine Steuervorrichtung auf, die eingerichtet ist, nach einem Zustandswechsel des Zündschalters eine Übermittlung von Konfigurations- und/oder Betriebsparametern an eine vorgebare Funkkommunikationseinrichtung im Access-Point-Mode, kurz Access-Point, oder eine vorgebbare Station vorzunehmen.

Vorteilhaft ist das Überwachungsmodul derart eingerichtet, dass die Funkkommunikation nach dem IEEE 802.11 (WLAN-) Standard erfolgt und das Überwachungsmodul im Ein-Zustand des Zündschalters mit einem WiFizertifizierten mobilen Endgerät verbindbar ist. In diesem Fall ist beispielsweise ein entsprechend zertifiziertes, handelsübliches Smartphone mit dem Überwachungsmodul verbindbar.

Vorteilhaft erlaubt eine drahtlose Übermittlung der Betriebsparameter über ein WLAN nach dem IEEE 802.11 Standard eine Übertragung der Daten über Strecken, abhängig von der Topologie, bis zu einigen hundert Metern. Die Reichweite eines des Überwachungsmoduls ist damit vorteilhaft geeignet, die beispielsweise in einem Fuhrpark von Baumaschinen zu überbrückenden Distanzen zu überwinden.

In einer vorteilhaften Ausgestaltung weist das Überwachungsmodul einen nichtflüchtigen Speicher zur Ablage von Messwerten (Betriebsstunden, Leerlaufspannung) oder einer Wartungshistorie auf. Die Wartungshistorie kann Wartungsnotizen enthalten, welche beispielsweise von einem Servicemitarbeiter mit Hilfe eines Smartphones an das Überwachungsmodul übermittelt werden können.

Zur Steuerung des Überwachungsmoduls weist dieses eine Steuervorrichtung auf, die eingerichtet ist, auf die Baumaschine bezogene Daten, insbesondere Wartungsberichte zu empfangen, zu speichern und, zum Beispiel auf Anfrage nach dem Request-Response-Prinzip, zu versenden.

Vorteilhaft weist das Überwachungsmodul eine Messvorrichtung zur Erfassung der Batteriespannung auf. Diese kann beispielsweise in Form eines Analog-digital-Wandlers ausgeführt sein, welcher die Batteriespannung, welche in einer vorteilhaften Ausgestaltungsform der Versorgungsspannung des Moduls entspricht, digitalisiert.

In dem Speicher abgelegte Werte oder Einträge werden vorteilhaft in einer Zeitreihe angelegt, so dass zurück verfolgt werden kann, zu welchem Zeitpunkt welche Werte gemessen oder übermittelt wurden.

Des Weiteren weist das Überwachungsmodul vorteilhaft einen Zeitgeber auf. Dieser ist zur Erfassung der Betriebszeit geeignet, welche näherungsweise als die Zeitdauer, in der der Zündschalter den Ein-Zustand aufweist, ermittelbar ist.

Darüber hinaus ist die Steuervorrichtung vorteilhaft dazu eingerichtet, im AusZustand des Zündschalters in einen Powerdown-Modus zu wechseln, den das Überwachungsmodul in vorgebbaren zeitlichen Abständen für die Erfassung von Betriebsparametern und für eine Funkkommunikation im Station-Mode zur Übertragung der Betriebsparameter zu einer vorgebbaren Funkkommunikationseinrichtung im Access-Point-Mode unterbricht. Dabei umfassen die Betriebsparameter den letzten erfassten Betriebszustand, insbesondere die letzte gemessene Spannung, die bisherige Anzahl Betriebsstunden sowie eventuelle neue Wartungsnotizen.

Weiterhin vorteilhaft ist die Steuervorrichtung des Überwachungsmoduls eingerichtet, Konfigurations- und/oder Betriebsparameter über einen Access-Point an einen vorgebbaren Server eines Netzwerkes zu übertragen, um die Daten einer weiteren Analyse zugänglich zu machen.

Beschrieben wird auch eine Smartphone-Applikation zur Konfiguration eines Überwachungsmodul mit vorbeschrieben Merkmalen, wobei die Smartphone-Applikation ausgeführt ist, über ein Smartphone eine Funkkommunikationsverbindung mit dem Smartphone im Station-Mode und dem Überwachungsmodul im Access-Point-Mode herzustellen und Konfigurationsund/oder Wartungsparameter von dem Smartphone an das Überwachungsmodul, oder Konfigurations- und/oder Betriebsparameter von dem Überwachungsmodul an das Smartphone zu übertragen. Mit Hilfe einer derartigen Applikation kann mit einem handelsüblichen Smartphone eine Verbindung zu dem beschriebenen Überwachungsmodul aufgebaut werden. Zusätzlich zu den bereits beschrieben Funktionen zur Verwendbarkeit eines Smartphones als Datenerfassungsterminal ist eine derartige Applikation für eine Erstkonfiguration bzw. Inbetriebnahme des Überwachungsmoduls einsetzbar. Weiterhin beschrieben ist eine Aggregationsvorrichtung zur Administration einer Mehrzahl von Überwachungsmodulen mit vorbeschrieben Merkmalen, wobei die Aggregationsvorrichtung einen Speicher, eine Netzwerkkommunikationsschnittstelle und eine Funkkommunikationseinrichtung aufweist, die zur Übertragung im Access-Point-Mode eingerichtet ist, sowie eine Steuervorrichtung aufweist, die eingerichtet ist, von einem Überwachungsmodul mit vorbeschrieben Merkmalen eine Mehrzahl gleichartiger Konfigurationsund/oder Betriebsparameter zu empfangen, in dem Speicher zu speichern und über die Netzwerkkommunikationsschnittstelle zu übertragen.

Die Aggregationsvorrichtung kann zum Abruf der Konfigurations- und/oder Betriebsparameter sämtlicher in Reichweite befindlichen Überwachungsmodule in regelmäßigen Intervallen ausgeführt sein. Je nach Konfiguration kann die Aggregationsvorrichtung eingerichtet sein, die Konfigurations- und/oder Betriebsparameter entweder lokal abzulegen, so dass diese mittels der Smartphone-Applikation gesammelt in einem Abruf verfügbar sind, oder die Aggregationsvorrichtung kann eingerichtet sein, die Konfigurations- und/oder Betriebsparameter über die Netzwerkkommunikationsschnittstelle an eine Netzwerk-Applikation zu übertragen.

Erfindungsgemäß vorgesehen ist zudem ein Verfahren zur Überwachung zumindest eines Betriebsparameters einer Baumaschine, wobei die Baumaschine eine Starterbatterie aufweist und mit einem Überwachungsmodul mit vorbeschrieben Merkmalen verbunden ist, die Betriebsparameter zumindest die Spannung der Starterbatterie umfassen, und das Verfahren die Schritte aufweist
1. Erfassung und Speicherung zumindest eines Betriebsparameters in einem Speicher des Überwachungsmoduls;
2. Übertragung des zumindest einen Betriebsparameters in einem Auszustand des Zündschalters an einen Access Point mit Router-Funktionalität oder an eine Aggregationsvorrichtung mit vorbeschrieben Merkmalen;
3. Übertragung des zumindest einen Betriebsparameters von dem Access Point mit Router-Funktionalität bzw. der Aggregationsvorrichtung an eine Auswerteeinheit in einem Netzwerk; wobei die Auswerteeinheit ein Server, ein PC, ein Laptop, ein Tablet-PC oder ein Smartphone sein kann und die Übertragung über das Internet erfolgen kann.
4. Zeitbasierte Auswertung über die Entwicklung der Spannung der Starterbatterie zur frühzeitigen Erkennung eines Spannungsabfalls, insbesondere durch eine Netzwerk-Applikation. Dabei beinhaltet die Netzwerk-Applikation eine Auswerte-Software, die auf der Auswerteeinheit ausgeführt wird.
5. Optional signalisiert die Netz-Applikation einem Abfall der Spannung der Starterbatterie unter einen vorgegebenen Grenzwert durch eine Mitteilung, wobei es sich bei der Mitteilung um eine E-Mail oder Kurzmitteilung handeln kann.

Nicht beansprucht wird auch eine Netzwerk-Applikation zur Auswertung von Konfigurations- und/oder Betriebsparametern von wenigstens einem Überwachungsmodul mit vorbeschrieben Merkmalen beschrieben, wobei die Netzwerk-Applikation eingerichtet ist, Konfigurations- und/oder Betriebsparametern von einem Überwachungsmodul mit vorbeschrieben Merkmalen oder einer Aggregationsvorrichtung mit vorbeschrieben Merkmalen zu empfangen, diese zeitbasiert auszuwerten und einen Spannungsabfall zu signalisieren.

Die Netzwerk-Applikation ermöglicht es, sämtliche Konfigurations- und/oder Betriebsparametern einschließlich gespeicherter Wartungsberichte für alle zu einem Netz gehöriger Überwachungsmodule chronologisch zu erfassen. Hierdurch wird eine zeitbasierte Auswertung über die Entwicklung der Konfigurations- und/oder Betriebsparameter einer überwachten Antriebsmaschine möglich, die unter anderem einen Spannungsabfall frühzeitig erkennbar macht.

Batterieausfall bedingte Wartungsaufwände und -kosten können damit reduziert werden. Die Anwendung ist mobiloptimierbar und kann auf gängigen internetfähigen Endgeräten (PC, Laptop, Tablet-PC, Smartphone) genutzt werden.

### Zeichnungen

Nachfolgend wird die Erfindung unter Bezugnahme auf die anliegenden, schematischen Zeichnungen näher erläutert. Dabei stellen die Figuren jeweils für sich keine jeweilige erfindungsgemäße Ausführungsform dar, vielmehr dienen sie dazu, bevorzugte Ausführungsformen von Komponenten und/oder die Aspekte der erfindungsgemäßen Anordnung zu veranschaulichen.

Es zeigen
- Fig. 1: eine Mehrzahl von Anordnungen aus einer Baumaschine und einem Überwachungsmodul, sowie deren alternative Funkverbindung zu einem Access Point oder zu einer Station;
- Fig. 2a: eine Anordnung aus einer Baumaschine und einem Überwachungsmodul, wobei der der Zündschalter den Aus-Zustand aufweist;
- Fig. 2b: eine Anordnung aus einer Baumaschine und einem Überwachungsmodul, wobei der der Zündschalter den Ein-Zustand aufweist;
- Fig. 3: ein Blockschaltbild einer Ausführung eines Überwachungsmoduls;
- Fig. 4a: eine Ausführung eines Überwachungsmoduls in einem Gehäuse mit standardisierten KFZ-Relais-Steckkontakten;
- Fig. 4b: die PIN-Belegung eines KFZ-Relais-Steckers;
- Fig. 5a: eine Ausführung eines Überwachungsmoduls in einem Gehäuse mit standardisiertem OBD-Stecker;
- Fig. 5b: die PIN-Belegung eines OBD (II) -Steckers.

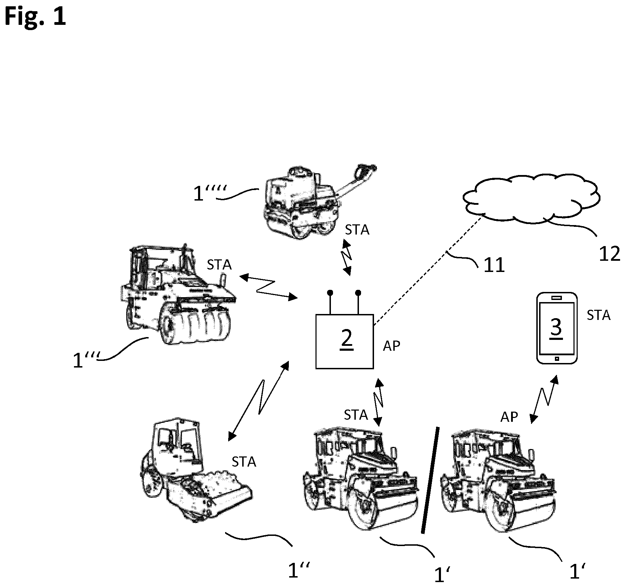

Fig. 1 zeigt eine Mehrzahl von Anordnungen 1′, 1ʺ, 1‴, 1ʺʺ aus einer Baumaschine und einem Überwachungsmodul 1. Nicht dargestellt weisen die Baumaschinen eine Starterbatterie und einen Zündschalter auf. Mit den Polen der Starterbatterie und mit dem geschalteten Kontakt des Zündschalters sind die Überwachungsmodule 1 über eine mehrpolige elektrische Steckverbindung lösbar verbunden.

Aus Fig.1 ist ersichtlich, dass die Überwachungsmodule 1 der Anordnungen 1′, 1ʺ, 1‴, 1ʺʺ Funkkommunikationseinrichtungen aufweisen, welche in einem Station-Mode STA betrieben werden, und mit denen die Anordnungen 1′, 1ʺ, 1‴, 1ʺʺ, beziehungsweise deren Überwachungsmodule 1, eine Funkverbindung zur Übertragung von Betriebsparametern zu einer weiteren, hier zentral angeordneten Funkkommunikationseinrichtung 2 aufbauen können. Dabei wird die weitere, zentral dargestellte Funkkommunikationseinrichtung 2 im Access-Point-Mode AP betrieben.

Die Funkkommunikationseinrichtung 2 kann Bestandteil einer Aggregationsvorrichtung oder eines handelsüblichen, vorzugsweise WiFizertifizierten WLAN Access-Points sein. Die Aggregationsvorrichtung oder handelsübliche WLAN Access-Points weisen eine Netzwerkkommunikationsschnittstelle auf, über welche eine Verbindung 11 mit dem Internet 12 herstellbar ist.

In dem Fall, in dem die Funkkommunikationseinrichtung 2 Bestandteil eines handelsüblichen Access Points ist, sind die Betriebsparameter von den Anordnungen 1′, 1ʺ, 1‴, 1ʺʺ über die Verbindung 11 an eine hier nicht dargestellte Auswerteeinheit (PC, Laptop, Tablet-PC, Smartphone) im Internet 12 direkt übermittelbar.

In dem Fall, in dem die Funkkommunikationseinrichtung 2 Bestandteil einer Aggregationsvorrichtung ist, sind die in der Aggregationsvorrichtung gesammelten Betriebsparameter von den Anordnungen 1′, 1ʺ, 1‴, 1ʺʺ über die Verbindung 11 gesammelt von einer hier nicht dargestellten Auswerteeinheit (PC, Laptop, Tablet-PC, Smartphone) im Internet 12 abrufbar.

Separiert durch einen nahezu senkrechten Trennstrich ist neben einer ersten Anordnung 1' aus einer Baumaschine und einem Überwachungsmodul eine zweite Anordnung 1' aus einer Baumaschine und einem Überwachungsmodul dargestellt. Am Beispiel der zweiten Anordnung 1' gezeigt, ist die Anordnung 1', bzw. die Funkkommunikationseinrichtung des mit der Baumaschine verbundenen Übertragungsmoduls alternativ im Access-Point-Mode AP betreibbar. Dies geschieht in dem Fall, in dem sich der Zündschalter der Baumaschine der Anordnung 1' im Ein-Zustand befindet. In diesem Zustand ist die Anordnung 1′ mit einer dritten, im Station-Mode befindlichen Funkkommunikationseinrichtung 3 verbindbar, welche beispielsweise integrierter Bestandteil eines Smartphones sein kann.

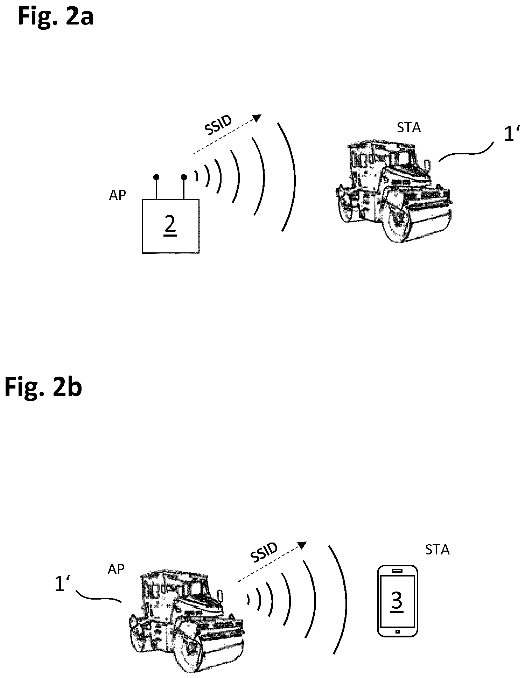

Die Figuren 2a und 2b zeigen den alternativen Betrieb der Anordnung 1' im Station-Mode, dargestellt in Fig. 2a, beziehungsweise im Access-Point-Mode, dargestellt in Fig. 2b.

Fig. 2a zeigt eine Funkkommunikationseinrichtung 2, welche im Access-Point-Mode in kurzen, sich wiederholenden Abständen einen Beacon aussendet, welcher eine SSID, einen Service Set Identifier, enthält. Damit bildet die Funkkommunikationseinrichtung 2 eine lokale Funkzelle bzw. ein lokales Funknetz aus, wobei der Name der Funkzelle/ des Funknetzes anhand der SSID erkennbar ist. Die Anordnung 1' ist eine Teilnehmerin dieses Funknetzes im Station-Mode.

In Fig. 2b wird die Ausbildung der Funkzelle/ des Funknetzes von der Anordnung 1' übernommen, die Funkkommunikationseinrichtung 3 in Form eines Smartphones ist eine Teilnehmerin dieses Funknetzes im Station-Mode.

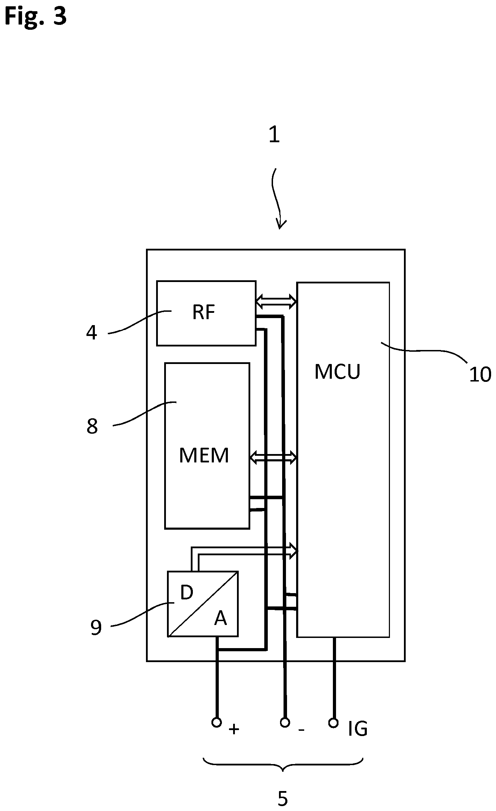

Fig. 3 zeigt ein Blockschaltbild eines Ausführungsbeispiels eines Überwachungsmoduls 1. Das Überwachungsmoduls 1 weist ein Stecker- oder Buchsen- Element 5 einer mehrpoligen elektrischen Steckverbindung zur Verbindung mit der Baumaschine auf, so dass es lösbar mit den Polen +/ - der Starterbatterie und mit dem Zündschalter IG der Baumaschine verbindbar ist. Zur Erfassung der Spannung einer Starterbatterie weist das Überwachungsmodul 1 einen Analog-digital-Wandler (A/D) 9 auf. In einem nicht-flüchtigen Speicher (MEM) 8 können Konfigurations- und/oder Betriebsparameter wie die Spannung der Starterbatterie abgespeichert werden. Dabei können die abgespeicherten Betriebsparameter auch über eine Funkkommunikationseinrichtung 4 empfangen worden sein, beispielsweise in Form von auf die Baumaschine bezogenen Wartungsnotizen.

Die Funkkommunikationseinrichtung (RF) 4 ist sowohl zum Betrieb in einem Station-Mode zur Funkkommunikation mit einem Access-Point 2 als auch zum Betrieb in einem Access-Point-Mode zur Funkkommunikation mit einer Station 3 eingerichtet. Die Steuerung ihres jeweiligen Betriebs wird von einer mikroprozessorbasierten Steuereinrichtung (MCU) 10 vorgenommen.

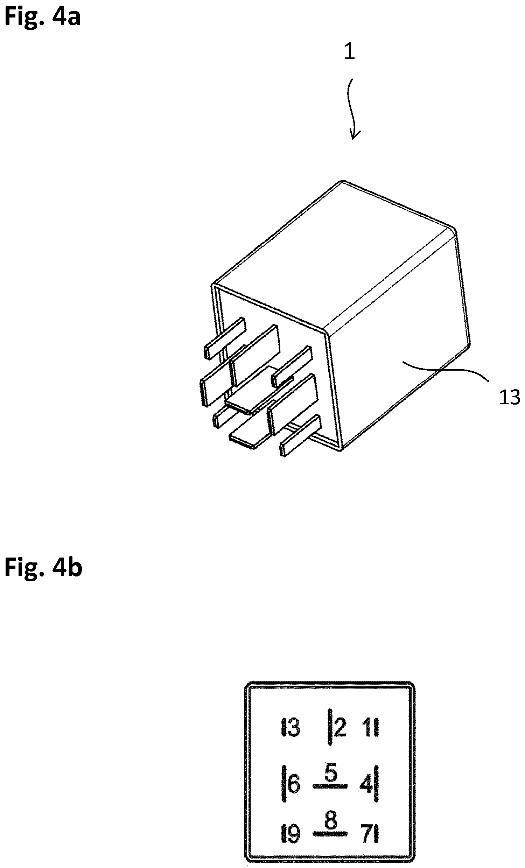

Figuren 4a/b zeigen ein Ausführungsbeispiel eines Überwachungsmoduls 1 in einem ersten Gehäuse 13 mit standardisierten KFZ-Relais-Steckkontakten. Fig. 4a zeigt das Überwachungsmodul 1 in perspektivischer Darstellung, Fig. 4b zeigt eine Aufsicht auf einen entsprechenden Sockel mit nummerierten PINs. Die PIN-Belegung des Sockels ist nicht einheitlich standardisiert. Eine PIN-Belegung kann beispielsweise derart gewählt werden, dass auf PIN 2 der Pluspol der Starterbatterie ("Dauerplus 30"), auf PIN 4 der Minuspol der Starterbatterie ("Masse 85") und auf PIN 7 der Zündschalter ("Zündung 15") zu liegen kommt, wobei die in Klammern gesetzten Angaben die in der KFZ-Technik üblichen Bezeichnungen darstellen.

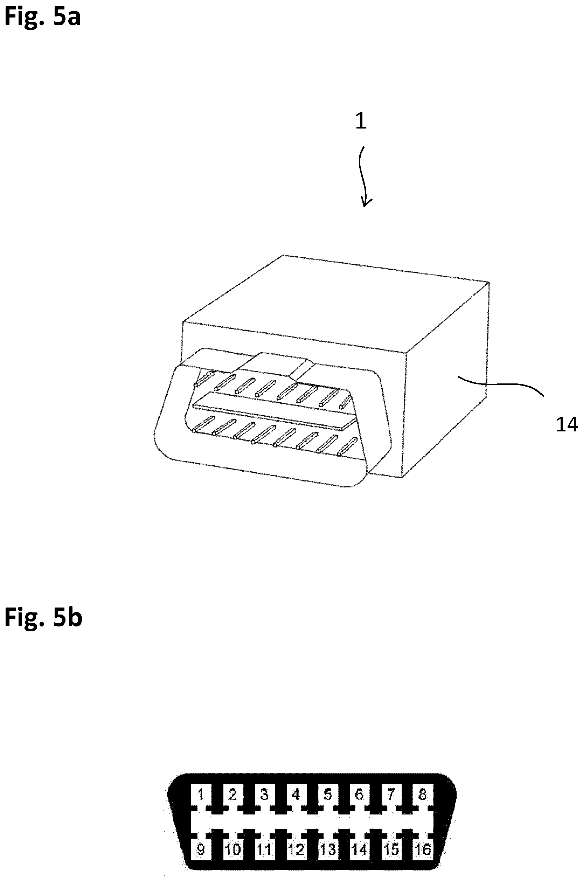

Figuren 5a/b zeigen ein Ausführungsbeispiel eines Überwachungsmoduls 1 in einem zweiten Gehäuse 14 mit einem in der Fahrzeugelektrik standardisierten OBD-Stecker. Fig. 4a zeigt das Überwachungsmodul 1 in perspektivischer Darstellung, Fig. 4b zeigt eine Aufsicht auf einen entsprechenden Sockel mit nummerierten PINs. Die PIN-Belegung des Sockels ist nur teilweise einheitlich standardisiert. Üblicherweise liegt die Batteriespannung auf PIN16 und die Fahrzeugmasse auf PIN4. Der Zustand der Zündung liegt bei einigen Herstellern auf PIN1 an.

## Patentansprüche

1. Anordnung aus einer Baumaschine und einem Überwachungsmodul (1) zur Erfassung von Betriebsparametern der Baumaschine, die eine Starterbatterie aufweist und über einen Zündschalter gestartet werden kann,
wobei die Betriebsparameter zumindest die Spannung der Starterbatterie der Baumaschine umfassen,
und wobei das Überwachungsmodul (1) zur drahtlosen Übermittlung der Betriebsparameter eine Funkkommunikationseinrichtung (4) aufweist,
wobei das Überwachungsmodul (1) ein Stecker- oder Buchsen- Element einer mehrpoligen elektrischen Steckverbindung zur Verbindung mit der Baumaschine aufweist, über die es lösbar mit den Polen der Starterbatterie und mit dem Zündschalter verbunden ist und eingerichtet ist, in einem AusZustand des Zündschalters die Funkkommunikationseinrichtung (4) in dem Station-Mode zur Funkkommunikation mit einem Access-Point zu betreiben und eine Übermittlung der erfassten Betriebsparameter an eine vorgebbare Funkkommunikationseinrichtung im Access-Point-Mode (2) vorzunehmen, und in einem Ein-Zustand des Zündschalters die Funkkommunikationseinrichtung (4) in einem Access-Point-Mode zur Funkkommunikation mit einer Station zu betreiben und eine Übermittlung der erfassten Betriebsparameter an eine vorgebbare Station (3) vorzunehmen.

2. Anordnung nach einem der vorherigen Ansprüche, **dadurch gekennzeichnet, dass** das Überwachungsmodul (1) als Stecker-Element einen Steckkontakt gemäß einem Standard-KFZ-Steckrelais oder einem Standard-OBD-Konnektor aufweist.

3. Anordnung nach einem der vorherigen Ansprüche, **dadurch gekennzeichnet, dass** das Überwachungsmodul (1) derart eingerichtet ist, dass die Funkkommunikation nach dem IEEE 802.11 WLAN-Standard erfolgt und das Überwachungsmodul (1) im Ein-Zustand des Zündschalters mit einem WiFizertifizierten mobilen Endgerät verbindbar ist.

4. Anordnung nach einem der vorherigen Ansprüche, **dadurch gekennzeichnet, dass** das Überwachungsmodul (1) eine Steuervorrichtung (10) aufweist und die Steuervorrichtung (10) eingerichtet ist, auf die Antriebsmaschine bezogene Daten, insbesondere Wartungsberichte, zu empfangen, zu speichern und zu versenden.

5. Anordnung nach einem der vorherigen Ansprüche, **dadurch gekennzeichnet, dass** das Überwachungsmodul (1) eine Steuervorrichtung (10) aufweist und die Steuervorrichtung (10) eingerichtet ist, im Aus-Zustand des Zündschalters in einen Powerdown-Modus zu wechseln, den das Überwachungsmodul (1) in vorgebbaren zeitlichen Abständen für die Erfassung von Betriebsparametern und für eine Funkkommunikation im Station-Mode zur Übertragung der Betriebsparameter zu einer vorgebbaren Funkkommunikationseinrichtung (2) im Access-Point-Mode unterbricht.

6. Anordnung nach einem der vorherigen Ansprüche, **dadurch gekennzeichnet, dass** das Überwachungsmodul (1) eine Steuervorrichtung (10) aufweist und die Steuervorrichtung (10) eingerichtet ist, Konfigurations- und/oder Betriebsparameter an einen vorgebbaren Server eines Netzwerkes zu übertragen.

7. Verfahren zur Überwachung zumindest eines Betriebsparameters einer Anordnung aus einer Baumaschine und einem Überwachungsmodul (1) nach einem der Ansprüche 1 bis 6, wobei das Verfahren die Schritte aufweist
i) Erfassung und Speicherung zumindest eines Betriebsparameters in einem Speicher (8) des Überwachungsmoduls (1);
ii) Übertragung des zumindest einen Betriebsparameters in einem AusZustand des Zündschalters an einen Access Point mit Router-Funktionalität oder an eine Aggregationsvorrichtung;
iii) Übertragung des zumindest einen Betriebsparameters von dem Access Point mit Router-Funktionalität bzw. der Aggregationsvorrichtung an eine Auswerteeinheit in einem Netzwerk und
iv) zeitbasierte Auswertung über die Entwicklung der Spannung der Starterbatterie zur frühzeitigen Erkennung eines Spannungsabfalls, insbesondere durch eine Netzwerk-Applikation.

## Claims

1. Arrangement consisting of a construction machine and a monitoring module (1) for gathering operating parameters of the construction machine, which has a starter battery and can be started via an ignition switch,
whereby the operating parameters comprise at least the voltage of the starter battery of the construction machine,
and whereby the monitoring module (1) has a radio communication device (4) for the wireless transmission of the operating parameters,
whereby the monitoring module (1) has a plug or socket element of a multipolar electrical plug connection for connection to the construction machine, through which it is detachably connected to the poles of the starter battery and the ignition switch, and set up to operate the radio communication device (4) in the station mode for the radio communication with an access point in an OFF position of the ignition switch and to transmit the gathered operating parameters to a specifiable radio communication device in the access point mode (2), and in an ON position of the ignition switch to operate the radio communication device (4) in an access point mode for the radio communication with a station and to transmit the gathered operating parameters to a specifiable station (3).

2. Arrangement according to one of the previous claims, **characterized in that** the monitoring module (1) has, as connecting element, a plug according to a standard motor vehicle plug relay or a standard OBD connector.

3. Arrangement according to one of the previous claims, **characterized in that** the monitoring module (1) is set up in such a way that the radio communication takes place according to the IEEE 802.11 WLAN standard and the monitoring module (1) can be connected in the ON position of the ignition switch to a WiFi-certified mobile terminal device.

4. Arrangement according to one of the previous claims, **characterized in that** the monitoring module (1) has one control device (10) and the control device (10) is set up to receive, store and send the data related to the drive unit, especially maintenance reports.

5. Arrangement according to one of the previous claims, **characterized in that** the monitoring module (1) has one control device (10) and the control device (10) is set up, in the OFF position of the ignition switch, to change to a powerdown mode, which interrupts the monitoring module (1) in specifiable chronological intervals for the gathering of operating parameters and for a radio communication in the station mode for transmitting the operating parameters to a specifiable radio communication device (2) in the access point mode.

6. Arrangement according to one of the previous claims, **characterized in that** the monitoring module (1) has one control device (10) and the control device (10) is set up for transmitting configuration and/or operating parameters to a specifiable network server.

7. Process for monitoring at least one operating parameter of an arrangement consisting of a construction machine and a monitoring module (1) according to one of the claims 1 to 6, whereby the process has the following steps
i) Gathering and storage of at least one operating parameter in a memory (8) of the monitoring module (1);
ii) Transmission of the at least one operating parameter in an OFF position of the ignition switch to an access point with router functionality or to an aggregation device;
iii) Transmission of the at least one operating parameter from the access point with router functionality or the aggregation device to an evaluation unit in a network and
iv) Time-based evaluation via the development of the voltage of the starter battery for the early detection of a voltage drop, especially via a network application.

## Revendications

1. Dispositif comprenant une machine de construction et un module de surveillance (1) pour la collecte des paramètres de fonctionnement de la machine de construction, qui possède une batterie de démarrage et peut être démarrée par l'intermédiaire d'un commutateur d'allumage,
les paramètres de fonctionnement comprenant au moins la tension de la batterie de démarrage de la machine de construction,
et le module de surveillance (1) possédant un dispositif de communication radio (4) pour la transmission sans fil des paramètres de fonctionnement,
le module de surveillance (1) présentant un élément de fiche ou de prise d'une connexion électrique multipolaire pour le raccordement à la machine de construction, par lequel il est relié de manière amovible aux pôles de la batterie de démarrage et au commutateur d'allumage et configuré pour faire fonctionner le dispositif de communication radio (4) dans le mode station pour la communication radio avec un point d'accès lorsque le commutateur d'allumage est en position OFF, et pour transmettre les paramètres de fonctionnement collectés à un dispositif de communication radio prédéfinissable dans le mode point d'accès (2) et, lorsque le commutateur d'allumage est en position ON, pour faire fonctionner le dispositif de communication radio (4) dans un mode point d'accès pour une communication radio avec une station et pour transmettre les paramètres de fonctionnement collectés à une station prédéfinissable (3).

2. Dispositif selon l'une des revendications précédentes, **caractérisé en ce que** le module de surveillance (1) présente un contact enfichable en tant qu'élément enfichable conformément à un relais enfichable automobile standard ou à un connecteur OBD standard.

3. Dispositif selon l'une des revendications précédentes, **caractérisé en ce que** le module de surveillance (1) est conçu de telle sorte que la communication radio s'effectue selon la norme IEEE 802.11 WLAN et que le module de surveillance (1) peut être connecté à un terminal mobile certifié WiFi lorsque le commutateur d'allumage est en position ON.

4. Dispositif selon l'une des revendications précédentes, **caractérisé en ce que** le module de surveillance (1) présente un dispositif de commande (10) et **en ce que** le dispositif de commande (10) est conçu pour recevoir, stocker et envoyer des données relatives à la machine d'entraînement, en particulier des rapports de maintenance.

5. Dispositif selon l'une des revendications précédentes, **caractérisé en ce que** le module de surveillance (1) présente un dispositif de commande (10) et **en ce que** le dispositif de commande (10) est configuré pour passer, lorsque le commutateur d'allumage est en position OFF, dans un mode de mise hors tension que le module de surveillance (1) interrompt à des intervalles de temps prédéfinissables pour la collecte de paramètres de fonctionnement et pour une communication radio en mode station afin de transmettre les paramètres de fonctionnement à un dispositif de communication radio prédéfinissable (2) en mode point d'accès.

6. Dispositif selon l'une des revendications précédentes, **caractérisé en ce que** le module de surveillance (1) présente un dispositif de commande (10) et **en ce que** le dispositif de commande (10) est conçu pour transmettre des paramètres de configuration et/ou de fonctionnement à un serveur réseau défini.

7. Procédé de surveillance d'au moins un paramètre de fonctionnement d'un dispositif d'une machine de construction et d'un module de surveillance (1) selon les revendications 1 à 6, le procédé présentant les étapes suivantes.
i) Enregistrement et stockage d'au moins un paramètre de fonctionnement dans une mémoire (8) du module de surveillance (1) ;
ii) transmission d'au moins un paramètre de fonctionnement, lorsque le commutateur d'allumage est en position OFF, à un point d'accès avec une fonctionnalité de routeur ou à un dispositif d'agrégation ;
iii) transmission d'au moins un paramètre de fonctionnement du point d'accès avec fonctionnalité de routeur ou du dispositif d'agrégation à une unité d'évaluation dans un réseau, et
iv) évaluation temporelle de l'évolution de la tension de la batterie de démarrage pour la détection précoce d'une chute de tension, en particulier via une application réseau.
